# EUROPEAN PATENT APPLICATION

(11) **EP 2 270 413 A1**
(43) Date of publication of application: **05.01.2011**
(21) Application number: 09162370.2
(22) Date of filing: 10.06.2009
(51) Int. Cl.: F28D 15/02, H01L 23/427

(54) **Anti-gravity thermosyphon heat exchanger and a power module**

(71) Applicant: ABB Research Ltd., 8050 Zürich (CH)
(72) Inventor: Agostini, Bruno, 8953 Dietikon (CH)
(74) Representative: ABB Patent Attorneys

(57) **Abstract**

The thermosyphon heat exchanger (1) according to the invention consists of a set (2; 21, 22) of linear conduit elements (4.1 to 4.15) and a heat exchange plate (3) mounted in a heat receiving region on the conduit elements (4.1 to 4.15). The longitudinal axes of the conduit elements (4.1 to 4.15) extend in a first direction in a plane defined by the flat side of the heat exchange plate (3). The conduit elements (4.1 to 4.15) project above the heat receiving region in the first direction on a first side and an opposing second side such that the extension of the conduit elements (4.1 to 4.15) on each side of the heat exchange region is suitable for constituting a condensing region for condensing a refrigerant vaporized in the heat receiving region if the first direction is arranged vertically.

## Description

The invention relates to an anti-gravity thermosyphon heat exchanger and a power module comprising an anti-gravity thermosyphon heat exchanger.

Classical thermosyphon heat exchangers comprise a heat receiving region at a bottom side of the thermosyphon heat exchanger for vaporizing a refrigerant and a condensing region at an upper side for condensing the vaporized refrigerant ascended to the condensing region. Some power electronic devices mounted on the thermosyphon heat exchanger are mounted upside-down, for example in traction applications. Thus, the power electronic device has to be remounted upside-down on the thermosyphon or cost-intensive anti-gravity thermosyphon heat exchanger have to be used to allow a flexible orientation of the power electronic devices mounted on the thermosyphon heat exchanger. On the one side, the remounting process is time and cost intensive and contains the risk to damage the expensive power electronic devices. Sometimes the power electronic modules are fixed such to the thermosyphon heat exchanger that an easy remounting of the power electronic module is not possible. On the other side, anti-gravity thermosyphon heat exchangers are very expensive, because of the use of special coatings in the conduit elements to move the refrigerant by capillary forces instead of gravity.

US 2007/0284093 A1 discloses an orientation insensitive thermosyphon. The disclosed thermosyphon shows a boiling chamber for vaporizing the refrigerant and two separate sets of conduit elements each extending from the boiling chamber in an angle of about 45° to the plane of the two major axes of the boiling chamber. Thus, the thermosyphon with the mounted power electronic device can be turned to 90° such that the power electronic device is mounted on the bottom side of the boiling chamber and the thermosyphon still works with gravity and without any capillary forces. The disadvantage of this thermosyphon is that it needs much mounting space and is difficult to fix because of the differently oriented planes of the thermosyphon. In addition, the construction of the thermosyphon is complicated, expensive and instable, because each set of conduit elements, which extend remarkably over the boiling chamber to guarantee effective condensing, has to be fixed to the boiling chamber and produce high leverage forces on the fixing point at the boiling chamber.

It is an object of the invention to find an orientation insensitive thermosyphon heat exchanger working without capillary forces and which has not the drawbacks of the state of the art thermosyphons. In particular, it is object of the invention to invent a less orientation sensitive thermosyphon heat exchanger that is easy to mount the thermosyphon heat exchanger having a basic, cheap and stable construction and requiring very little mounting space only.

As to the heat exchanger, the object is solved by a thermosyphon heat exchanger according to claim 1. The thermosyphon heat exchanger comprises at least one set of linear conduit elements comprising at least one linear conduit element and at least one heat exchange plate mounted in a heat receiving region on the conduit elements. The term linear shall not be understood in a narrow sense as to be strictly straight only. Geometrical variations as curves for example shall be included as long as the function is not detrimentally affected. The longitudinal axes of the conduit elements extend in a first direction running through or being parallel to a plane defined by the biggest side, in the following called also flat side, of the heat exchange plate. The conduit elements exceed over, i.e. extend beyond, the heat receiving region in the first direction on a first side and a second side opposing the first side such that the extension of set of linear conduit elements on one of the first or second side of the heat receiving region constitutes a condensing region for condensing a refrigerant vaporized in the heat receiving region if this first or second side is arranged higher than the extension on the other side with respect to the direction of gravity in an operating state and that the extension of said other side constitutes a liquid reservoir. That means each of said extensions is suitable for constituting a condenser region for condensing a refrigerant vaporized in the heat receiving region if the first direction is arranged vertically and the function of each extension depends on the orientation of the heat exchanger.

The object is solved as well by a power module according to claim 14. Said power module comprises at least one heat emitting device and one thermosyphon heat exchanger with at least one heat exchange plate as described above. The at least one heat emitting device is thermally connected to the at least one heat exchange plate.

Such a thermosyphon heat exchanger combines the advantages of the state of the art and overcomes their drawbacks. The thermosyphon heat exchanger can be mounted even with a 180° rotation of the thermosyphon heat exchanger together with the power electronic modules mounted thereon, because after the rotation, the extension of the conduit elements before on the bottom side is rotated on the top side of the heat receiving region. Thus, in both positions there exists a top extension of the conduit elements for condensing the vaporized refrigerant. There is no need for expensive anti-gravity thermosyphons using capillary forces. In addition, the conduit elements extend on both sides of the heat receiving region only in the first direction and thereby, the claimed thermosyphon has a flat construction and is easy to mount at the application place and does not need much space.

The dependent claims refer to advantageous embodiments of the invention.

In one embodiment, the extension on the first side and the extension on the second side are arranged symmetrically to a symmetry axis of the thermosyphon heat exchanger. In one embodiment, this symmetry axis is perpendicular to the first direction and runs in the direction of the arrangement of the conduit elements. The region of the extension of the conduit elements suitable for condensing has the same size on both sides of the heat receiving region. By rotating the thermosyphon 180° around the third axis being rectangular to the first direction and the direction of the conduit elements-arrangement, the condensing region, i.e. the extension of the conduit elements at the top side of the heat receiving region, remains equal. The same advantages apply, if heat receiving region is arranged in the middle between first ends of the conduit elements and second ends of the conduit elements.

In one embodiment, the set of linear conduit elements comprises at least a first manifold connecting first ends of the conduit elements and a second manifold connecting second ends of the conduit elements. The easy and efficient way of construction by a plurality of conduit elements arranged between two manifolds guarantees a stable and cheap base construction of a thermosyphon. In a further embodiment, each manifold has a closable opening for filling and/or discharging the refrigerant and the closable opening of the first manifold is point symmetrical to the centre of the thermosyphon heat exchanger to the closable opening of the second manifold. Thus, upon rotating the thermosyphon 180°, the first opening is at the place of the second opening before and the thermosyphon has the same form. Therefore, the mounting space reserved for the thermosyphon and its opening has not to be changed upon rotation of the thermosyphon. The centre of the thermosyphon refers to the centre point of the plane of the first direction and the direction in which the conduit elements are arranged.

In another embodiment, the thermosyphon heat exchanger has fixing devices for fixing the thermosyphon heat exchanger and the fixing devices are arranged point symmetric to a centre point of the thermosyphon heat exchanger. This is especially in combination with the point symmetrical arrangement of closable openings advantageous and has the same advantages.

In an embodiment, the conduit elements are multiport extruded tubes so that cheap, stable and effective conduit elements from the automotive sector can be used.

In an embodiment of the thermosyphon heat exchanger, when first ends of the conduit elements are arranged at a higher position compared to second ends of the conduit elements or contrariwise, the thermosyphon heat exchanger is filled with the refrigerant such that the conduit elements in the heat receiving region are filled with the refrigerant and the extension of the conduit elements on the upper side of the heat receiving region remains empty. Therefore, the upper extension of the conduit elements, irrespective which extension actually points upwards, works as a condenser for the vaporized refrigerant.

In one embodiment, the heat exchange plate is soldered to the conduit elements. Especially for heat exchange plates soldered to the conduit elements, it is advantageous for the heat exchange plate to be soldered in the middle of the thermosyphon such that the orientation of the thermosyphon can be changed by rotation. If the position of the heat exchange plate would be easy changeable, the power electronic device could be rotated together with heat exchange plate and could be remounted in the new orientation. But a soldered heat exchange plate has better heat transportation characteristics, such that a solution for an orientation insensitive thermosyphon heat exchanger is needed.

The heat exchange plate is connected to all conduit elements to achieve maximum heat transportation from the heat exchange plate to the conduit elements.

The conduit elements are continuous from the extension on the first side of the heat receiving region to the second side. This has the advantage that the construction of the thermosyphon heat exchanger is stable and optimal vapor and refrigerant transportation characteristics are achieved by continuous conduit elements.

In another embodiment of the invention, the thermosyphon heat exchanger has a second set of linear conduit elements. The longitudinal axes of the conduit elements of the second set are arranged in a second direction in or parallel to said plane. This has the advantage that despite two sets of linear conduit elements the construction space in the direction rectangular to said plane is not increased remarkably. In addition, the cooling performance of the thermosyphon heat exchanger is improved for all states of rotation of the thermosyphon heat exchangers within the plane of the heat exchange plate, because there are two sets of conduit elements with different angles to the vertical direction. In one embodiment the second direction is rectangular to the first one. This further improves the cooling performance, because at least one set of conduit elements is always arranged in an angle less than 45° to the vertical direction.

In another embodiment, the described crossed arrangements of two sets of linear conduit elements is efficiently and easy achieved by rectangular crossing two simple thermosyphon heat exchangers with only one set of linear conduit elements, wherein the crossing region corresponds to the region of the heat exchange plates of both thermosyphon heat exchangers. The heat exchange plates are thermally connected. This increases the produced number of simple thermosyphon heat exchanger and saves production costs.

In the following, a first and a second embodiment are described on the basis of the drawing. The drawing shows
- Fig. 1: a schematic, three-dimensional illustration of a first embodiment of the thermosyphon heat exchanger according to the invention;
- Fig. 2: a cross-sectional view of the heat exchange plate of the first embodiment of the thermosyphon heat exchanger according to the invention;
- Fig. 3: a cross-sectional view of heat exchange plates of a variation of the first embodiment of the thermosyphon heat exchanger according to the invention;
- Fig. 4: a schematic illustration of the first embodiment of the thermosyphon heat exchanger according to the invention showing the three-dimensional position within a coordinate system;
- Fig. 5: a schematic illustration of the first embodiment of the thermosyphon heat exchanger according to the invention showing a first exemplary inclination within the x-z plane of the coordinate system;
- Fig. 6: a schematic illustration of the first embodiment of the thermosyphon heat exchanger according to the invention showing a second exemplary inclination within the x-z plane of the coordinate system;
- Fig. 7: a schematic illustration of the first embodiment of the thermosyphon heat exchanger according to the invention showing an exemplary inclination within the x-y plane of the coordinate system;
- Fig. 8: a schematic illustration of a second embodiment of the thermosyphon heat exchanger according to the invention showing the three-dimensional position within a coordinate system;
- Fig. 9: a schematic illustration of the second embodiment of the thermosyphon heat exchanger according to the invention showing an exemplary inclination within the x-y plane of the coordinate system; and
- Fig. 10: a schematic illustration of a heat exchange plate of the second embodiment.

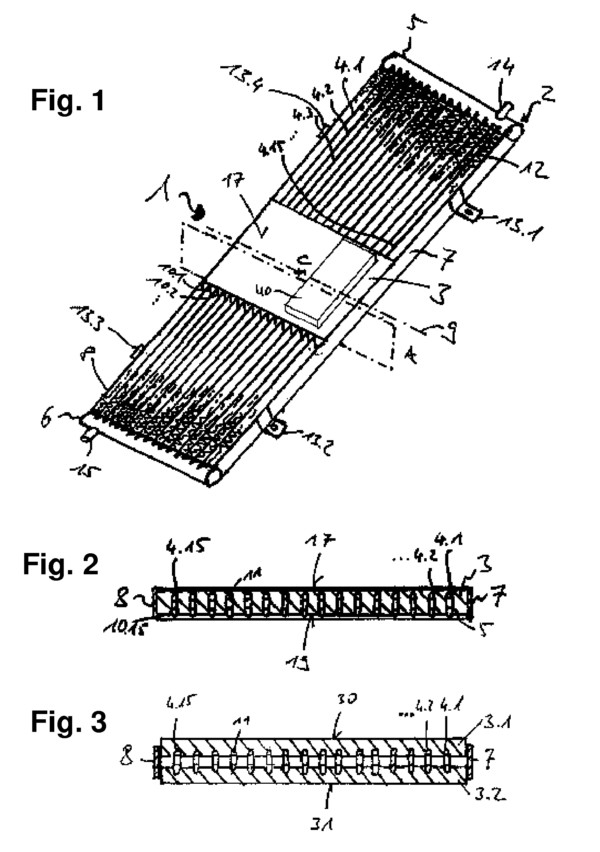

Fig. 1 shows a three-dimensional view on the exemplary inventive thermosyphon heat exchanger 1. The thermosyphon heat exchanger 1 consists of one set 2 of multiport extruded tubes 4.1 to 4.15 as conduit elements and a heat exchange plate 3 mounted on the set 2 of multiport extruded tubes 4.1 to 4.15. The multiport extruded tubes 4.1 to 4.15 within the set 2 are arranged within a plane. The set 2 of multiport extruded tubes 4.1 to 4.15 comprises as well two manifolds 5 and 6. The multiport extruded tubes 4.1 to 4.15 are arranged between the first manifold 5 and the second manifold 6.

The manifolds 5 and 6 are circular cylinders which are arranged in parallel. The multiport extruded tubes 4.1 to 4.15 are arranged perpendicular to the cylinder axes of the manifolds 5 and 6 at the circular outer walls of the manifolds 5 and 6. The rectangular arrangement does not restrict the invention since even another angular arrangement is possible, but the rectangular arrangement is especially stable and space-saving. The longitudinal axis of each multiport extruded tube 4.1 to 4.15 extends in a first direction. The longitudinal axis of the manifolds 5 and 6 extend in a second direction, in the preferred embodiment, perpendicular to the first direction.

The multiport extruded tubes 4.1 to 4.15 within the set 2 are arranged in one single row and parallel to each other. The set 2 is additionally stabilized by the frame elements 7 and 8 which are mounted on the ground areas of the cylinders of the manifolds 5 and 6 or at the circular walls next to the ground areas of the cylinders of the manifolds 5 and 6. This arrangement is preferred, but does not restrict the invention. An alternative set can have different rows of multiport extruded tubes 4.1 to 4.15, wherein each row contain parallel several multiport extruded tubes 4.1 to 4.15. The only condition for the invention is that each couple of multiport extruded tubes 4.1 to 4.15 is pair wise parallel, i.e. that the longitudinal axis of each multiport extruded tube 4.1 to 4.15 within one set elongates along the first direction.

Each of the multiport extruded tubes 4.1 to 4.15 is linear and continuous. Each of the multiport extruded tubes 4.1 to 4.15 consists of several separated sub-tubes which open at the first and second end of the multiport extruded tubes 4.1 to 4.15. The construction of the multiport extruded tube 4.1 to 4.15 by several sub-tubes has the advantage that on the one hand, a maximum contact surface between the refrigerant and the multiport extruded tubes 4.1 to 4.15 is established and on the other hand, a thick multiport extruded tube with several sub-tubes is much more stable than a number of thin, individual tubes. The multiport extruded tubes 4.1 to 4.15 are connected in such to the manifolds 5 and 6 that the openings of the sub-tubes of the multiport extruded tubes 4.1 to 4.15 at their first and second ends open into the first and second manifold 5 and 6, respectively, and that no refrigerant liquid or vapor can leak the closed cooling circuit.

The heat exchange plate 3 is connected to the multiport extruded tubes 4.1 to 4.15 in a heat receiving region of the set 2 of multiport extruded tubes 4.1 to 4.15 in the middle between the manifolds 5 and 6, preferably by soldering. The heat receiving region is identical to the region covered by the heat exchange plate 3 in the plane spanned by the first and second direction. In the preferred embodiment, the heat exchange plate 3 is arranged such on the multiport extruded tubes 4.1 to 4.15 that each multiport extruded tube 4.1 to 4.15 projects the heat exchange plate 3 on a first side of the heat exchange plate 3 in the same manner as on a second side of the heat exchange plate. The first side of the heat exchange plate 3 refers to the side in the first direction versus the first manifold 5 and the second side to the side in the second direction versus the second manifold 6. Since the multiport extruded tubes 4.1 to 4.15 are linear and continuous, the first and second sides oppose each other. Each multiport extruded tube 4.1 to 4.15 extends the heat exchange plate 3 on both sides with the same length and the same angle, preferably 90°. In different words, the multiport extruded tubes 4.1 to 4.15 between the first side and the first manifold 5 has the same length as between the second side and the second manifold 6. Therefore, when the first direction points in a vertical direction and e.g. the first manifold 5 is the top manifold, rotating the thermosyphon heat exchanger 1 around 180° around the centre point C of the thermosyphon does not change the size of the region between the top side of the heat exchange plate 3 and the top manifold. In this example, the top manifold before the rotation is manifold 5 and after the rotation it is manifold 6. Thus, the preferred embodiment has always the like condensing region, i.e. the region between a top manifold and the heat receiving region, upon rotation of the thermosyphon heat exchanger 1. The region between the first manifold 5 and the first side is arranged symmetrically to a symmetry axis 9 to the region between the second manifold 6 and the second side.

The region between the first manifold 5 and the heat receiving region could in another embodiment even be smaller than the region between the second manifold 6 and the heat exchange plate 3. It is important that the smaller region is still suitable to cool down and condense the vaporized refrigerant. The size of such a condensing region depends strongly on the heat amount produced by the power electronic device to be cooled down and by the characteristics of the refrigerant, on the cooling characteristics of the multiport extruded tubes 4.1 to 4.15 in the condensing region and on the power of probably used external cooling fans. Such a non-symmetric division of the extensions of the multiport extruded tubes on both sides of the heat exchange plate 3 could be advantageous for power cooling devices which are only rarely mounted upside-down or for cooling devices which need a lower cooling power if mounted upside-down.

Any device to be cooled down can be mounted on the heat exchange plate 3. The exemplary thermosyphon heat exchanger 1 is especially convenient for power electronic modules or power electric modules which are normally soldered to the heat exchange plate 3 for an optimal heat transport. For illustration reasons only one heat emitting device 40 is shown. Fig. 2 shows a cross-sectional view A of the thermosyphon heat exchanger 1 at the height of the heat exchange plate 3. The heat exchange plate 3 has grooves 10.1 to 10.15 each in a shape corresponding to the shape of the profile and in the same arrangement of the multiport extruded tubes 4.1 to 4.15 such that the heat exchange plate 3 can be easily plugged with the grooves 10.1 to 10.15 on the first multiport extruded tubes 4.1 to 4.15 and soldered thereon. The grooves 10.1 to 10.15 have approximately the same depth as the first multiport extruded tubes 4.1 to 4.15 such that a maximum contact surface of the multiport extruded tubes 4.1 to 4.15 with the surface of the heat exchange plate 3 in the grooves 10.1 to 10.15 is established and the grooves 10.1 to 10.15 surround the first multiport extruded tubes 4.1 to 4.15 on three sides. The meaning of surrounding in this application and in the context of the grooves 10.1 to 10.15 includes not only the encasing of the multiport extruded tubes 4.1 to 4.15 by the grooves 10.1 to 10.15, but also the encompassing of the first multiport extruded tubes 4.1 to 4.15 with the maximum contact to them which still allows the plugging of the heat exchange plate 3 on the multiport extruded tubes 4.1 to 4.15. The encasing has the drawback that once the heat exchange plate 3 is mounted on the multiport extruded tubes 4.1 to 4.15, it cannot be taken off without taking off one of the cylinders 5 or 6. But the encasing still increases the contact surface between the heat exchange plate 3 and the multiport extruded tubes 4.1 to 4.15. The heat exchange plate 3 is soldered to the multiport extruded tubes 4.1 to 4.15 to establish optimal heat conductivity from the heat exchange plate 3 to the multiport extruded tubes 4.1 to 4.15 or to the refrigerant within them, respectively.

Fig. 2 shows the parallel arrangement of the multiport extruded tubes 4.1 to 4.15. The profile of the multiport extruded tubes 4.1 to 4.15 is basically rectangular, wherein the smaller sides of the rectangle are formed circular here. The flat sides are larger than the circular sides and the multiport extruded tubes 4.1 to 4.15 are arranged in parallel to each other such that the larger sides face each other to guarantee maximum space between the multiport extruded tubes 4.1 to 4.15. This infers high cooling air flow speeds and a maximum surface the air flow can pass. This is especially important for the region where the heat exchange plate 3 is not mounted. Preferably, the flat sides of the multiport extruded tubes 4.1 to 4.15 have approximately the same size as the cylinder-diameter of the manifolds 5 and 6 or a little bit smaller. The thickness, i.e. the size of the smaller side, of the profile of the multiport extruded tubes 4.1 to 4.15 has to be chosen regarding the cooling requirements, available cooling power of the cooling air flow and the properties of the refrigerant in a liquid and vaporized state. The properties of the refrigerant determine as well the form, number and size of the sub-tubes 11 in the multiport extruded tubes 4.1 to 4.15.

Fig. 1 shows cooling fins 12 in the region between the first manifold 5 and the first side of the heat exchange plate 3 and between the second manifold 6 and the second side between neighbored multiport extruded tubes 4.1 to 4.15 and between the marginal multiport extruded tubes 4.1 and 4.15 and the frame elements 7 and 8, respectively. The cooling fins increase the surface of the multiport extruded tubes 4.1 to 4.15 with whom they are in direct thermal contact. Thus, the heat of the vaporized refrigerant can be more efficiently transported from the condensing region to the ambiance by convection. A cooling air flow is created either artificially by a cooling fan or naturally by an air flow created by temperature differences between the ambiance and the air between the multiport extruded tubes 4.1 to 4.15.

The thermosyphon heat exchanger 1 has fixing elements 13.1 to 13.4 arranged at the frame elements 7 and 8. In this embodiment, the fixing elements are angle brackets. One bracket arm is fixed at the frame element 7 or 8 and the other bracket arm has a hole. The thermosyphon heat exchanger 1 can be fixed by screws, bolts or other fixation means through the hole to a fixing wall or a fixing mechanism adapted to the arrangement of the fixing elements 13.1 to 13.4. In the preferred embodiment, the arrangement of the fixing elements 13.1 to 13.4 is point symmetric to the centre point C, which is in the middle between the ends of the multiport extruded tubes 4.1 to 4.15 and in the middle between the two frame elements 7 and 8 or in the middle between the marginal multiport extruded tubes 4.1 and 4.15.

The thermosyphon heat exchanger 1 has two refrigerant connections 14 and 15 as closable opening for filling and discharging the thermosyphon 1 with the refrigerant. The first refrigerant connection 14 is arranged as a in the first direction projecting connection on the side of the circular wall of the first manifold 5 being opposite to the connections of the multiport extruded tubes 4.1 to 4.15 at the first manifold 5. Normally, thermosyphon heat exchangers of the state of the art have only one refrigerant connection, such that in a fixed position, the refrigerant can either be filled in or be discharged. For example, if the refrigerant connection would be only at a top manifold, a state of the art thermosyphon could be fixed and filled with refrigerant, but cannot be discharged in a mounted state. If the exemplary state of the art thermosyphon heat exchanger is mounted upside-down the thermosyphon has to be filled before fixing it, because the refrigerant connection would be upon rotation at the bottom manifold. Therefore, two refrigerant connections have the advantage that the thermosyphon heat exchanger 1 can be filled and discharged while being fixed in any of its operational directions. The refrigerant connections 14 and 15 are arranged such that they are symmetric to the centre point C. Thus, the first refrigerant connection 14 arrives after the rotation of the thermosyphon around 180° around the centre point at the place of the second refrigerant connection 15 before the rotation. Therefore, eventually needed spaces for the refrigerant connections 14 and 15 in a fixing ambiance have not to be changed upon fixing the thermosyphon heat exchanger 1 in an upside-down position.

In the preferred embodiment, the complete thermosyphon heat exchanger 1 is constructed symmetrical to the centre point C in the plane of the first and second direction such that the thermosyphon heat exchanger 1 upon rotation of about 180° around the centre point C has the same characteristics as before the rotation. Exemplary characteristics are the size, the borderline, the functionality, the fixing positions of the thermosyphon heat exchanger 1, the positions of the refrigerant connections 14 and 15 and the position, size and design of the regions between the sides of the heat exchange plate 3 and the manifolds 5 and 6, respectively.

The preferred mounting position of the thermosyphon heat exchanger 1 is such that the first direction is a vertical direction that means that gravity force points in the same direction as the first direction. But the invention is not restricted by the preferred mounting direction, but the first direction can even show any angle except 90° and 270° from the vertical direction. Important is that one of the two manifolds 5 and 6 is arranged at a higher position with respect to the vertical direction than the other manifold. In such a fixed position, the thermosyphon heat exchanger 1 is filled by the top refrigerant connection with the refrigerant until the bottom manifold, the multiport extruded tubes 4.1 to 4.15 in the region between the bottom manifold and the bottom side of the heat exchange plate 3 and in the heat receiving region is filled with refrigerant. The multiport extruded tubes 4.1 to 4.15 remain empty in the region between top side of the heat exchange plate 3 and the top manifold and even the top manifold remains empty. Then, the top refrigerant connection is closed such that a closed cooling circuit is achieved. If the thermosyphon heat exchanger 1 would be remounted in an upside-down position, the refrigerant filling level fulfils the same condition as described above.

Fig. 3 shows an alternative embodiment of the first embodiment with respect to the heat exchange plate 3. In the alternative embodiment on two sides of the set 2 of multiport extruded tubes 4.1 to 4.15 with respect of the plane of the multiport extruded tubes 4.1 to 4.15 a first and a second heat exchange plate 3.1 and 3.2 is mounted on the multiport extruded tubes 4.1 to 4.15. Each of the first and second heat exchange plate 3.1 and 3.2 has on one side grooves which have a profile like the profile of the multiport extruded tubes 4.1 to 4.15 of the set 2. The first heat exchange plate 3.1 is bonded with the grooves to a first side of the set 2 of multiport extruded tubes 4.1 to 4.15 with respect to the plane of the set 2 such that all multiport extruded tubes 4.1 to 4.15 enter in the corresponding grooves of the first heat exchange plate 3.1. Each multiport extruded tube 4.1 to 4.15 enters at maximum with half the dimension of the multiport extruded tube 4.1 to 4.15 in the groove such that at least another half of the multiport extruded tube 4.1 to 4.15 is not surrounded by the first heat exchange plate 3.1. The at least other half of the multiport extruded tubes 4.1 to 4.15 is at least partly entered into the grooves of the second heat exchange plate 3.2. Thus, the thermosyphon heat exchanger of the alternative embodiment offers mounting surfaces 30 and 31 on two sides of the set 2.

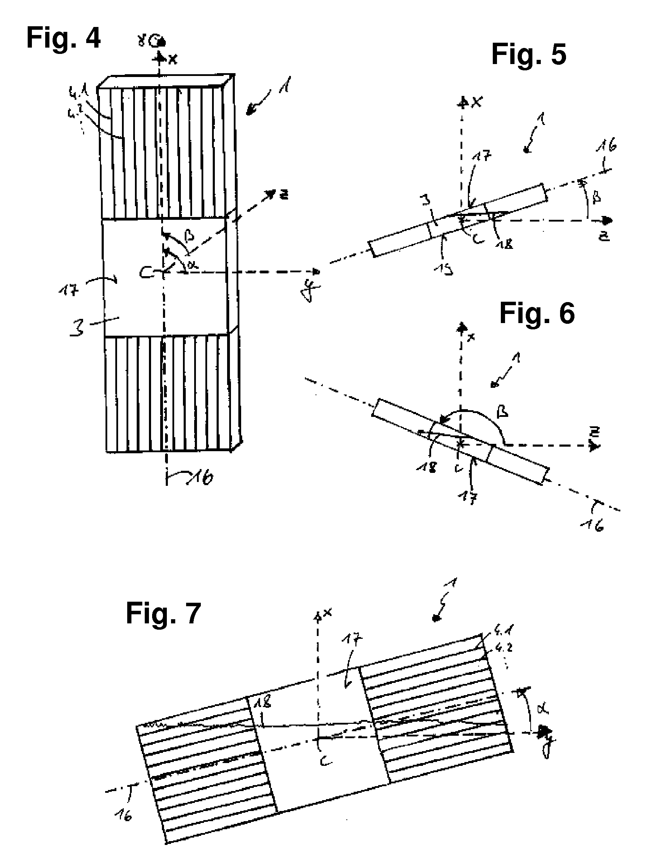

Fig. 4 shows a schematic illustration of the first embodiment of the invention, however less detailed than in Fig. 1. Fig. 4 shows a three-dimensional Cartesian coordinate system with the three directions x, y and z. The coordinate systems are fixed and defined such that the x-direction points against the gravitation. Fig. 4 illustrates the position of the thermosyphon heat exchanger 1 of the first embodiment in the three-dimensional space. The longitudinal axis 16 of the thermosyphon heat exchanger 1, illustrated by dash-dotted line, points in the first direction, i.e. in the direction of the longitudinal axes of all multiport extruded tubes 4.1 to 4.15 of the set 2, and passes the centre point C. The centre point C coincides with the origin of the coordinate system and is the point of rotation of the thermosyphon heat exchanger 1. The longitudinal axis 16 even coincides in the illustrated position of Fig. 4 with the x-direction of the coordinate system, shown by a dashed line. The angle α is the angle between the vertical direction and the projection of the longitudinal axis on the x-y-plane. The angle β is the angle between vertical direction and the projection of the longitudinal axis 16 on the x-z-plane. The angle γ is the angle of rotation of the thermosyphon heat exchanger 1 around the x-axis.

In the illustrated example, α and β are 90° and γ is here defined as 0°, but the following description applies accordingly to all angles of γ. If the thermosyphon heat exchanger 1 is inclined out of the plane defined by the flat side of the heat exchange plate from the vertical direction to a horizontal direction, i.e. decreasing β versus 0° or increasing β versus 180°, the refrigerant in the thermosyphon heat exchanger 1 partly flows from the heat receiving region into the condensing region, which is the upper extension of the multiport extruded tubes 4.1 to 4.15. Fig. 5 and 6 show an exemplary inclination in the x-z-plane with β smaller than 90° and β larger than 90°, respectively and α equal 90° and illustrate the level 18 of the liquid refrigerant in the thermosyphon heat exchanger 1. In this example in Fig. 5, without restriction of the invention, the mounting surface 17 of the heat exchange plate 3 for mounting power electronic devices points in the negative z-direction.

Consequently, if the angle β is decreased as shown in Fig. 5, the thermosyphon heat exchanger 1 is inclined such that the side 19 opposing the mounting surface 17 points versus the ground and approaches there with decreasing angles β. Thus, the liquid refrigerant next to the mounting surface 17, in the upper region of the heat exchange plate 3 flows into the bottom part of the condensing region. At a certain angle β next to 0° the parts of the power electronic devices mounted in the parts of the mounting surface 17 being not in contact with the liquid refrigerant enlarges such that the power electronic devices cannot be efficiently cooled down any more. However, for the major part of the angular region β, the thermosyphon heat exchanger 1 works well. Certainly, the same holds for angles β between 270° and 360°, because of the symmetry of the thermosyphon heat exchanger 1.

On the other side, if the angle β is increased as shown in Fig. 6, the thermosyphon heat exchanger 1 is inclined such that mounting surface 17 points versus the ground and approaches there with decreasing angles β. Thus, the mounting surface 17 is always in contact with the refrigerant, because the liquid refrigerant flows from the opposing side 19 of the heat exchange plate 3 into the bottom part of the condensing region. Consequently, the angle β can be increased almost to 0°. However at 0°, the thermosyphon heat exchanger 1 malfunctions as well, because the vaporized refrigerant cannot rise to the condensing region being at the same gravitational potential level. Certainly, the same holds for angles β between 180° and 270°, because of the symmetry of the thermosyphon heat exchanger 1.

More problematic is the inclination of the thermosyphon heat exchanger 1 such that the thermosyphon heat exchanger 1 is rotated within the plane defined by the flat side of the heat exchange plate 3, i.e. varying angle α. Fig. 7 shows an exemplary inclination with α smaller than 90° and β equal 90° in the x-y-plane and illustrates the level 18 of the liquid refrigerant in the thermosyphon heat exchanger 1. If α is decreased, the liquid refrigerant flows from the upper part of the heat receiving region and even from the bottom extension region filled with liquid refrigerant into the condensing region. Thus, the smaller the angle α becomes, the effective condensing region, i.e. the top extension part not flooded with liquid refrigerant, decrease and the effective heat receiving region of the heat exchange plate 3, i.e. the region of the heat exchange plate 3 having filled multiport extruded tubes 4.1 to 4.15, decreases. Therefore, the cooling performance decrease until at a certain angle β some power electronic devices are not in thermal contact with liquid refrigerant and the cooling performance for these power electronic devices dramatically decreases. Therefore, thermosyphon heat exchanger 1 according to the first embodiment of the invention can be operated only between 10° and 90° or between 90° and 170° or between 190° and 350° with respect to the angle α.

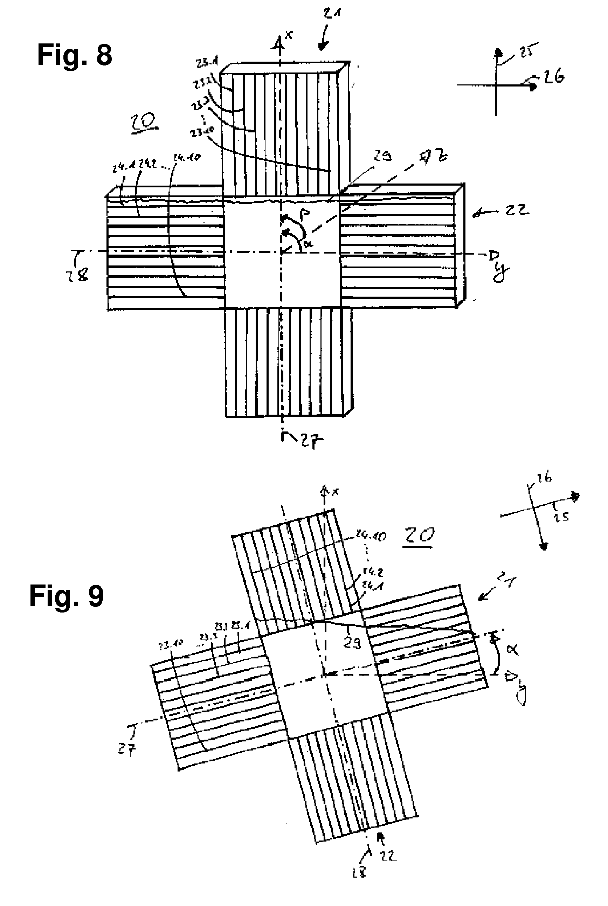

Fig. 8 and 9 illustrate a thermosyphon heat exchanger 20 according to a second embodiment of the invention. The thermosyphon heat exchanger 20 comprises a first set 22 of multiport extruded tubes 23.1 to 23.10 and a second set 23 of multiport extruded tubes 24.1 to 24.10. Each set 21 and 22 is designed as set 2 of the first embodiment of the invention including manifolds, fins, refrigerant connections, fixing devices, etc. The multiport extruded tubes 23.1 to 23.10 or 24.1 to 24.10 within one set 21 or 22 are arranged with their longitudinal axes in parallel. The multiport extruded tubes 23.1 to 23.10 of the first set 21 are arranged in a first plane and their longitudinal axes point all in a first direction 25. Thus, the first set 21 has a longitudinal axis 27 pointing in the same direction as the longitudinal axis of the multiport extruded tubes 23.1 to 23.10. The multiport extruded tubes 24.1 to 24.10 of the second set 22 are arranged in a second plane parallel to and neighboring the first plane and their longitudinal axes point all in a second direction 26. Thus, the second set 22 has a longitudinal axis 28 pointing in the same direction as the longitudinal axis of the multiport extruded tubes 24.1 to 24.10. The second direction 26 is rectangular to first direction and parallel to the first and second plane. The two sets 21 and 22 are arranged such that there is a crossing region and four equally sized regions of extensions projecting over the crossing region. Each region of extension is suitable for condensing vaporized refrigerant if the extension is a top part of a set having a longitudinal axis pointing in vertical direction, here the upper part of the set 21.

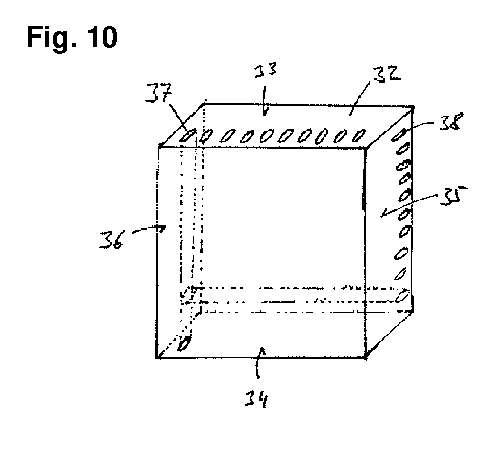

Both sets 21 and 22 are thermally connected via a common heat exchange plate 32 as illustrated in Fig. 10. The heat exchange plate 32 has a number of first holes 37 linearly extending from a first side 33 to a second side 34. The heat exchange plate 32 has a number of second holes 38 linearly extending from a third side 35 to a fourth side 36. The profile of the holes 37 and 38 corresponds to the profile of the multiport extruded tubes 23.1 to 23.10 and 24.1 to 24.10. The number of holes and their arrangement correspond to the number of multiport extruded tubes 23.1 to 23.10 or 24.1 to 24.10 of the set 22 or 23 and their arrangement within the set 22 or 23. Thus, the first holes 37 hold the multiport extruded tubes 23.1 to 23.10 and the second holes 38 hold the multiport extruded tubes 24.1 to 24.10. The flat side of the heat exchange plate 32 is quadratic.

In an alternative embodiment, each set 21 and 22 has a heat exchange plate mounted on the corresponding multiport extruded tubes of each set 21 and 22 as the heat exchange plate 3 is mounted on the set 2. Since the heat exchange plates are mounted each in the middle of the set 21 and 22, the heat exchange plates are both in the crossing region of the two sets 21 and 22. The heat exchange plates have quadratic flat sides, such that the crossing region is covered by both heat exchange plates. The heat exchange plates are thermally connected by thermal grease for example. Alternatively, the heat exchange plates are soldered to each other. The thermal connection between the heat exchange plates can be further improved by heat pipes.

Fig. 8 shows the position of the thermosyphon heat exchanger 20 according to the second embodiment of the invention in the x-y-z coordinate system introduced in Fig. 3. Accordingly, the angles α and β define the same angles of inclination with respect to the first longitudinal axis 27 of the first set 21. In the illustrated position, the first longitudinal axis 27 points in a vertical direction and the second longitudinal axis 28 in a horizontal direction. The angles α and β are 90° and the thermosyphon heat exchanger 20 is filled up in this position until the complete heat receiving region, here identical with the crossing region, is filled up until the level 29 with liquid refrigerant. Consequently, in this position the 3 regions of extensions are filled up with liquid refrigerant and only the upper extension is empty suitable for condensing vaporized refrigerant. In other words, the horizontally arranged set 22 of multiport extruded tubes 24.1 to 24.10 is filled up with liquid refrigerant, while the vertically arranged set 21 of multiport extruded tubes 23.1 to 23.10 is filled up with liquid refrigerant only in the bottom region of extension and in the crossing region.

Upon inclining the thermosyphon heat exchanger 20 within the plane formed by the first and second direction, i.e. increasing or decreasing α, liquid refrigerant moves from the horizontally arranged set 22 from the side of the set 22 which rises upon rotation into the empty condensing region of the vertically arranged set 21 which rotates out of the vertically position upon rotation. Fig. 9 shows the decrease of the angle α, i.e. a clockwise rotation. Upon rotation, the set 21 moves versus a horizontal orientation and the set 22 versus a vertical orientation such that after rotation of the thermosyphon heat exchanger 20 about 90° the set 22 is vertically arranged and the set 21 is horizontally arranged. Therefore, the cooling performance of the thermosyphon heat exchanger 20 does not decrease upon rotation in the plane of the heat exchange plates as in the first embodiment of the invention. The multiport extruded tubes 23.1 to 23.10 and 24.1 to 24.10 within the heat receiving region remain always filled with liquid refrigerant. At least one set 21 or 22 of multiport extruded tubes 23.1 to 23.10 or 24.1 to 24.10 or its longitudinal axis has an angle of 45° or less to the vertical direction such that an effective flow of the vaporized refrigerant into the empty parts of this set 21 or 22 is guaranteed.

It is noticed that in the second embodiment, the longitudinal axis of the second set 22 and the longitudinal axis of the manifold of the set 21 point both in the second direction 26. It is also possible that the longitudinal axis of the second set 22 point in the second direction and the longitudinal axis of the manifold of the set 21 point in a third direction.

The Figs. 3 to 9 show only schematically the invention. For example the level 18 or 29 of liquid refrigerant illustrates the level of refrigerant within the multiport extruded tubes 23.1 to 23.10 or 24.1 to 24.10 or 4.1 to 4.15. Even formulations like "the heat receiving region, the heat exchange plate, the condensing region, the crossing region or the extension is filled with liquid refrigerant or is empty" refers not to the whole region but only to the inner volume of the multiport extruded tubes 23.1 to 23.10 or 24.1 to 24.10 or 4.1 to 4.15 in said regions.

The material of the heat exchange plate 3, the manifolds 5, 6 and the multiport extruded tubes is preferably aluminium or any aluminium alloy which combines good heat conduction properties with small weight.

All geometric descriptions of arrangements are not restricted to the mathematical exact definition but also include the impreciseness of production and arrangements which nearly correspond to the described arrangements.

The vertical direction is the direction along or against the gravitation force.

The invention is not restricted to the described embodiments. All embodiments described are combinable with each other. A preferred embodiment does not restrict the invention to the preferred embodiment, alternatives or combinations with other embodiments are included in the scope of protection.

## Claims

1. Thermosyphon heat exchanger with at least one set (2; 21, 22) of linear conduit elements (4.1 to 4.15; 23.1 to 23.10, 24.1 to 24.10) and with at least one heat exchange plate (3; 3.1, 3.2; 32) being mounted in a heat receiving region to the linear conduit elements (4.1 to 4.15; 23.1 to 23.10, 24.1 to 24.10), whereby longitudinal axes of the linear conduit elements (4.1 to 4.15; 23.1 to 23.10, 24.1 to 24.10) are arranged in a first direction running through or being parallel to a plane defined by the heat exchange plate (3; 3.1, 3.2; 32) and wherein the at least one set of linear conduit elements (4.1 to 4.15; 23.1 to 23.10, 24.1 to 24.10) extends beyond the heat receiving region on a first side and on an opposing second side in the first direction (25) such that the extension of the at least one set of linear conduit elements (4.1 to 4.15; 23.1 to 23.10, 24.1 to 24.10) on one of the first and second sides of the heat receiving region constitutes a condensing region for condensing a refrigerant vaporized in the heat receiving region if this first or second side is arranged higher than the extension on the other side with respect to the direction of gravity in an operating state of the thermosyphon heat exchanger and that the extension of said other side constitutes a liquid reservoir.

2. Thermosyphon heat exchanger according to claim 1, **characterized in that** the heat receiving region is arranged in about the middle between first ends of the linear conduit elements (4.1 to 4.15; 23.1 to 23.10, 24.1 to 24.10) and second ends of the linear conduit elements (4.1 to 4.15; 23.1 to 23.10, 24.1 to 24.10).

3. Thermosyphon heat exchanger according to claim 1 or 2, **characterized in that** the at least one set (2; 21, 22) of linear conduit elements (4.1 to 4.15; 23.1 to 23.10, 24.1 to 24.10) comprises a plurality of linear conduit elements (4.1 to 4.15; 23.1 to 23.10, 24.1 to 24.10), wherein an longitudinal axis of each linear conduit element of the at least one set (2; 21, 22) of linear conduit elements is arranged in the first direction (25).

4. Thermosyphon heat exchanger according to anyone of claims 1 to 3, **characterized in that** the at least one set (2; 21, 22) of linear conduit elements comprises at least a first manifold (5) connecting first ends of the linear conduit elements (4.1 to 4.15; 23.1 to 23.10, 24.1 to 24.10) and a second manifold (6) connecting second ends of the linear conduit elements (4.1 to 4.15; 23.1 to 23.10, 24.1 to 24.10).

5. Thermosyphon heat exchanger according to claim 4, **characterized in that** each manifold (5, 6) has a closable opening (14, 15) for filling and/or discharging the thermosyphon heat exchanger by the refrigerant and the closable opening (14) of the first manifold (5) is arranged about point symmetrical to a centre (C) of the thermosyphon heat exchanger to the closable opening (15) of the second manifold (6).

6. Thermosyphon heat exchanger according to anyone of claims 1 to 5, **characterized in that** the thermosyphon heat exchanger has fixing devices (13.1 to 13.4) for fixing the thermosyphon heat exchanger and the fixing devices (13.1 to 13.4) are arranged about symmetrically to a centre point (C) of the thermosyphon heat exchanger.

7. Thermosyphon heat exchanger according to anyone of claims 1 to 6, **characterized in that** the linear conduit elements (4.1 to 4.15; 23.1 to 23.10, 24.1 to 24.10) are multiport extruded tubes.

8. Thermosyphon heat exchanger according to anyone of claims 1 to 7, **characterized in that** when first ends of the linear conduit elements (4.1 to 4.15; 23.1 to 23.10, 24.1 to 24.10) are arranged at a higher level in a vertical direction compared to the corresponding second ends of the linear conduit elements (4.1 to 4.15; 23.1 to 23.10, 24.1 to 24.10) or second ends of the linear conduit elements (4.1 to 4.15; 23.1 to 23.10, 24.1 to 24.10) are arranged at a higher level in a vertical direction compared to first ends of the linear conduit elements (4.1 to 4.15; 23.1 to 23.10, 24.1 to 24.10), the thermosyphon heat exchanger is filled with the refrigerant such that the linear conduit elements (4.1 to 4.15; 23.1 to 23.10, 24.1 to 24.10) in the heat exchanger region is filled with the refrigerant and the extension of the linear conduit elements (4.1 to 4.15; 23.1 to 23.10, 24.1 to 24.10) on the upper side of the heat receiving region remains empty suitable for condensing the vaporized refrigerant.

9. Thermosyphon heat exchanger according to anyone of claims 1 to 8, **characterized in** further comprising a further set (22) of linear conduit elements (24.1 to 24.10), wherein a longitudinal axis of the linear conduit elements (24.1 to 24.10) of the further set (22) is arranged in a second direction (26) in or parallel to said plane.

10. Thermosyphon heat exchanger according to claim 9, **characterized in that** the second direction (26) extends transversely to the first direction (25), in particular about perpendicularly to the first direction.

11. Thermosyphon heat exchanger according to claim 9 or 10, **characterized in that** the further set (22) of linear conduit elements (24.1 to 24.10) is thermally connected to the heat exchange plate in a crossing region of the set (21) of linear conduit elements and the further set (22) of linear conduit elements (4.1 to 4.15; 23.1 to 23.10, 24.1 to 24.10).

12. Thermosyphon heat exchanger according to anyone of claims 1 to 11, **characterized in that** the linear conduit elements (4.1 to 4.15; 23.1 to 23.10, 24.1 to 24.10) of at least one of the sets (2; 21, 22) of linear conduit elements and/or of the further set (22) of linear conduit elements is continuous from the extension on the first side of the heat receiving region to the second side.

13. Power module comprising at least one heat emitting device and at least one thermosyphon heat exchanger with at least one heat exchange plate (3; 3.1, 3.2; 32) according to one of claims 1 to 12, whereby the at least one heat emitting device is thermally connected to the at least one heat exchange plate (3; 3.1, 3.2; 32).

14. Power module according to claim 13 **characterized in that** the at least one heat emitting device comprises at least one of a power electronic device and a power electric device.
